# EUROPEAN PATENT APPLICATION

(11) **EP 4 657 040 A1**
(43) Date of publication of application: **03.12.2025**
(21) Application number: 24178495.8
(22) Date of filing: 28.05.2024
(51) Int. Cl.: G01M 7/00

(54) **METHOD FOR DETERMINING A FAILURE RATE OF AN ELECTRICAL CONNECTOR**

(71) Applicant: Aptiv Technologies AG, 8200 Schaffhausen (CH)
(72) Inventor: PORTE, Maxime, 90471 Nuremberg (DE)
(74) Representative: INNOV-GROUP

(57) **Abstract**

The invention is directed to a method for determining a failure rate (%B) of a batch (B) of electrical connectors (C), comprising the following steps:
- making at least one sample (S) of electrical connector (C) degraded so as to exhibit a contact normal force (F) lesser than a force threshold (FT), lesser than the mean force (FM) of the batch (8),
- determining a probability (P) of occurrence of said at least one sample (S) within the batch (8), in function of the threshold force (FT),
- applying a vibrating test to said at least one sample (S),
- obtaining a failure rate (%S) of the sample (S),
- calculating a failure rate (%B) of the batch (B) by multiplying the failure rate (%S) of the sample (S) by the probability (P).

## Description

### Technical domain

The invention concerns a method for determining a failure rate of an electrical connector.

### Prior art

Connectors and terminals failure rates are important information for evaluating the reliability of electrical functions in the field of automotive and especially autonomous driving and e-mobility.

It has been already identified that the possible micro-movement between the male and female terminals due to system vibrations or thermal expansion cycles, is the most contributing factor in the contact degradation, said contact degradation leading to a contact resistance increase, ultimately causing electrical failure in field.

Some technical papers report that a minimum number of electrical random failure might happen in a time frame of 10⁹ operating hours. Accordingly, a failure rate is generally expressed in FIP unit, one FIP being one failure per 10⁹ operating hours.

In the meanwhile, it is important to understand that a standard connector vibration test might be able to simulate around 250.000 operating hours (10 years x 500 op. hours per year x 50 samples). This test requires a lot of efforts to be set and its duration is around 3 weeks. Moreover, due to usual quite stable contact resistances during the test, such a test does not provide enough failures to be significant. Any extrapolation to failure (in order to evaluate the life duration) will be either impossible or at least associated with really low confidence in the result, when the time window of extrapolation is too large.

So, several options might be considered to increase the number of simulated operating hours in order to avoid false result extrapolation from product validation testing (in which no or minimum wear / micro-movements happen):
- repeat the vibration test by a multiplicative factor X until obtaining significant product failures. A major drawback is the tremendous amount of time needed,
- severize the test (by raising temperature / vibration amplitude) with a multiplicative factor Y to cause earlier failures. The problem is mainly that test conditions are already set close to the limits in order to match field degradation mechanisms. In case of any additional test severization, there is a strong risk to activate other degradation mechanisms (material fatigue and wear) that could not be correlated to reality / field experience anymore,
- increase the quantity of samples in test by a multiplicative factor Z. Here again a major drawback is the raised cost. Usual test works on 50 samples, which is already a lot, having 1000 or more connectors in test is not possible.

The previous points enable to understand how difficult is to play with the vibration test conditions to simulate more connector operating hours and thus to calculate a failure rate (or FIT rate) with a good confidence level.

Accordingly, a method for determining a failure rate of an electrical connector, within a reasonable time and costs is of primary interest.

### Summary of the invention

The invention is directed toward an innovative solution to this problem.

The object of the invention is a method for determining a failure rate of a batch of electrical connectors, comprising the following steps:
- making at least one sample of electrical connector degraded so as to exhibit a contact normal force lesser than a force threshold, lesser than the mean force of the batch,
- determining a probability of occurrence of said at least one sample within the batch, in function of the threshold force,
- applying a vibrating test to said at least one sample,
- obtaining a failure rate of the sample,
- calculating a failure rate of the batch by multiplying the failure rate of the sample by the probability.

Some specific features or embodiments, usable alone or in combination, are:
- the degradation of the sample is done by mechanical, vibratory and/or thermal ageing until reaching the normal force wished,
- the sample is from the batch,
- the probability is determined by assuming a normal distribution of the normal force within the batch,
- the threshold force is chosen distant from the mean force at least off 3σ, by lesser value,
- the vibrating test is applied according to an automotive norm, such as the norm DIN/TS 70214:2024-01,
- the failure rate of the sample, is determined by the ratio of the number of failing sample at the end of the vibrating test, by the total number of sample,
- a sample S is failing when his connector resistance is greater than a resistance threshold,
- a prolongation of the duration of the vibrating test is simulated by extrapolating the connector resistance according to a lognormal or Weibull law, until obtaining the failure,
- the total number of sample is at least equal to fifty.

### Drawings

Others features, details and advantages of the invention will become more apparent from the detailed illustrating description given hereafter with respect to the drawings on which:
[Fig. 1] shows, a normal distribution,
[Fig. 2] shows, a diagram of the method.

### Detailed description

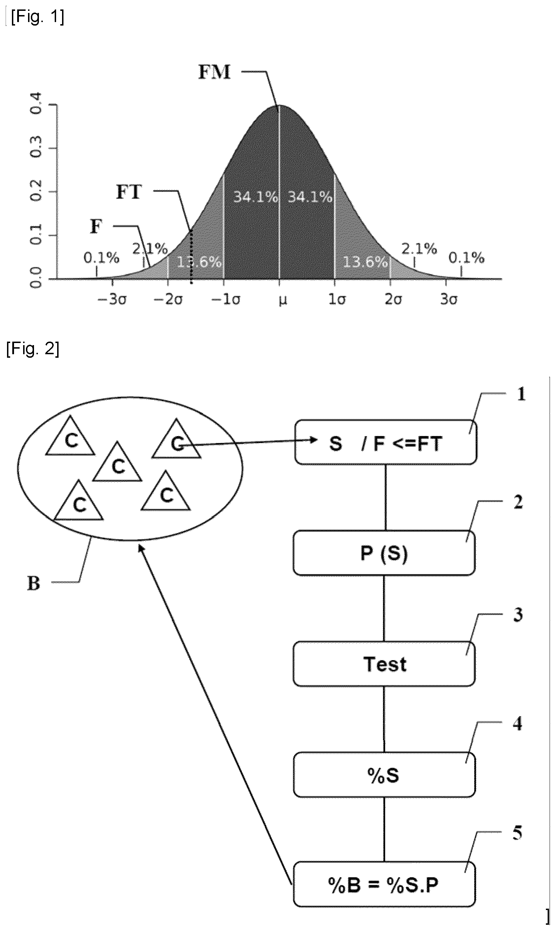

As illustrated in figure 2, the invention concerns a method for determining a failure rate %B of a batch B of electrical connectors C. An electrical connector C gather at least two terminals. Said terminals are tested in contact one with each other. To simulate the operating lifespan of a connector, a connector is submitted to a vibrating test according to a vibrating profile.

The vibrating profile is designed to be representative of the operating environment of the connector during its life. For example, a connector in an automobile is submitted to vibrations of certain waves shapes and intensities. The vibrating profile reflects this: the applied vibrating profile is indicative of the automobile vibrations. However, said vibrating profile is "amplified", typically in amplitude or in occurrences, in order to simulate a quicker ageing, in order to save time.

During its lifespan, of typically 10 years, a connector C is operational during 500 operative hours. By using 50 connectors samples parallelly tested, this is equivalent to 250 000 operating hours. This can be simulated by a 3 weeks standard test, that is about 500 h. However, despite this "acceleration" of a 500 factor, 250 000 hours is far from the goal of 10⁹ operating hours, where failures are about to occur.

Accordingly, the aim of the invention is to be able to "accelerate" the process furthermore.

The main idea of the invention is to consider that the normal force F of the connector C is a most influent parameter to induce an electrical failure. The lesser the normal force F, the shorter the life of the connector C. Moreover, it is assumed that said normal force F can be probabilistically correlated to the failure rate %S.

In order to ensure a maintained connection between the at least two terminals, an elasticity of at least one of the terminals is required. Said elasticity leads to a measurable force appearing between the at least two terminals. The normal component, that is the component measured perpendicularly with respect to the contact, of said force, is called the normal force F.

The main idea of the invention is to apply a vibrating test to a sample S showing a reduced normal force F. Since the normal force F is reduced, the connector C is expected to fail sooner, leading either to a shortened vibrating test duration, and thus a gain of time, or to a vibrating test ending nearer to a failure, thus increasing the confidence level of the test's result, by minimizing the amount of extrapolation needed.

Knowing the distribution of connectors C according to their normal force F, it is possible to determine a probability P of occurrence of such a sample S of connector C.

The vibrating test provides a failure rate %S of said degraded sample S.

It is then possible to calculate a failure rate %B for the whole batch B by multiplying the failure rate %S of the sample S by the probability P.

So the method comprises the following steps, as illustrated in figure 2:
- Step 1: making at least one sample S of electrical connector C degraded so as to exhibit a reduced contact normal force F, that is lesser than a force threshold FT, so at least lesser than the mean force FM of the batch B,
- Step 2: determining a probability P of occurrence of said at least one sample S within the batch, in function of the threshold force FT,
- Step 3: applying a vibrating test to said at least one sample S,
- Step 4: obtaining a failure rate %S of the sample S,
- Step 5: calculating a failure rate %B of the batch B by multiplying the failure rate %S of the sample S by the probability P.

During a first step 1, a sample S is made. Starting from a connector C, its normal force F can be measured. If the normal force F is lesser than a force threshold FT, said connector C can become a sample S. If the normal force F is greater than the force threshold FT, the connector C is operated until its normal force F become lesser than the force threshold FT.

Said operating, intended to degrade the normal force F, can be mechanical, vibratory and/or thermal. Mechanical means a direct action, such as alternate plying, applied to at least one of the terminals in order to reduce the connector's rappelling force and thus the normal force F. Vibratory means applying a vibration profile, in order to age the connector C. This is quite similar to applying a vibrating test, leading to an accelerated ageing. Thermal means applying a thermal profile, in order to age the connector C in a similar way. Whatever the degradation method chosen, the normal force F is measured, and the connector C becomes a valid sample S, when said normal force F is lesser than or equal to the force threshold FT.

In order for a sample S to be representative of the batch B, as illustrated in figure 2, said sample S is made from a connector C selected from the batch B, whose failure rate %B is to be determined.

Knowing the normal force F of a sample S, during a second step 2, its probability P can be determined by knowing the distribution of normal force F within the batch B.

Said distribution is a function giving a probability of occurrence P in function of the normal force F. Knowing the manufacturing characteristic of batches B produced, one can determine the type of distribution encountered.

For this purpose, the distribution of the normal force F can be assumed to be a gaussian or a normal distribution within the batch B, as illustrated in figure 1. The gaussian function is known and is fully characterized by its mean µ, here the mean force FM and its standard deviation σ, both known for each batch B. Accordingly, the normal force F or alternately the threshold force FT, can be associated to a probability P of occurrence. Reciprocally, for a given probability P, the normal force F can be determined, when asserting a value either lesser or greater than the mean force FM, due to the symmetry of the normal distribution.

The threshold force FT is chosen a small as possible. The smaller the normal force F is, the sooner a failure could be expected. So the force threshold FT is chosen distant from the mean force FM. The lesser the normal force F or the threshold force FT is, the lower the probability P is, thus leading to a greater multiplying factor. However, if the normal force F becomes too small, confidence level of the test could become at stake and it could be difficult to obtain such a degradation of the normal force F. A good trade on is a force threshold FT value between 3 σ and 6 σ from the mean force FM, by lesser value.

E.g at 6 σ, negative side, the normal force F is 33 % lesser than the mean force FM. The probability of occurrence is 1/294100. This leads to a probability of occurrence of 1/147050. A 2 factor must be introduced to take into account both sides of the distribution curve. This allows a 147050 multiplying factor.

The threshold force FT can be related to the acceptance threshold of the production, in order to be 1 σ below. For example, if the batch B is of a production whose acceptance threshold is 3 σ: a connector is considered good if its normal force F is comprised between - 3 σ and 3 σ, the force threshold FT of the degraded sample S could preferably be at 4 σ from the mean force FM, by lesser value.

The vibrating test used to test the at least one sample S can be any vibrating test, as long as its profile is relevant to the intended usual use of the connector C and the test's duration can be related to a real use duration.

According to another feature, the vibrating test is applied according to an automotive norm. Said norm can be e.g. the norm DIN/TS 70214:2024-01.

Among the at least one sample S submitted to the test, some of them would eventually fails during the application of the vibrating test. The failure rate %S of said at least one sample S, is determined, during fourth step 4, par dividing the number of failing sample S at the end of the vibrating test, by the total number of sample S.

To determine if a sample S had failed, the electrical connector resistance R is used. During the lifespan of a connector C, or during a vibrating test, the electrical resistance R of the connector C tends to rise. It rises until it becomes too high, leading to a degradation of the connector or even to fire. The electrical connector resistance R can be measured. Thus, a resistance threshold RT, indicative of a failure, is chosen. A sample S is considered to be failing when, at the end of the vibrating test, his connector resistance R is greater than said resistance threshold RT.

When, among other causes, the normal force F is not enough degraded, the vibrating test could not be sufficient to obtain a (significant amount of) failure. In such a case, a prolongation of the duration of the vibrating test can be simulated by extrapolating the connector resistance R according to a lognormal or Weibull law, until obtaining the failure. This may be necessary to avoid a failure rate %S equal to zero.

The failure rate %S of the sample S or the failure rate %B of the batch B can be made to the scale. For instance, to get failure rates in FIP unit, they must be multiplied by 10⁹.

In order to provide a multiplying factor without increasing too much the cost of the vibrating test, the total number of sample S is at least equal to fifty.

While there is shown and described the present preferred embodiment of the invention, it is to be distinctly understood that this invention is not limited thereto but may be variously embodied to practice within the scope of the following claims.

### List of reference signs

B: batch,
C: connector,
F: normal force,
FM: mean force,
FT: threshold force,
P: probability,
R: connector resistance,
RT: resistance threshold,
S: sample,
%B: batch failure rate,
%S: sample failure rate,
1-5: method step.

## Claims

1. A method for determining a failure rate (%B) of a batch (B) of electrical connectors (C), ***characterized in that it comprises*** the following steps:
- making at least one sample (S) of electrical connector (C) degraded so as to exhibit a contact normal force (F) lesser than a force threshold (FT), lesser than the mean force (FM) of the batch (B),
- determining a probability (P) of occurrence of said at least one sample (S) within the batch (B), in function of the threshold force (FT),
- applying a vibrating test to said at least one sample (S),
- obtaining a failure rate (%S) of the sample (S),
- calculating a failure rate (%B) of the batch (B) by multiplying the failure rate (%S) of the sample (S) by the probability (P).

2. The method according to claim 1, wherein the degradation of the sample (S) is done by mechanical, vibratory and/or thermal ageing until reaching the normal force (F) wished.

3. The method according to anyone of claims 1 or 2, wherein the sample (S) is from the batch (B).

4. The method according to anyone of claims 1 to 3, wherein the probability (P) is determined by assuming a normal distribution of the normal force (F) within the batch (B).

5. The method according to anyone of claims 1 to 4, wherein the threshold force (FT) is chosen distant from the mean force (FM) at least off 3σ, by lesser value.

6. The method according to anyone of claims 1 to 5, wherein the vibrating test is applied according to an automotive norm, such as the norm DIN/TS 70214:2024-01.

7. The method according to anyone of claims 1 to 6, wherein the failure rate (%S) of the sample (S), is determined by the ratio of the number of failing sample (S) at the end of the vibrating test, by the total number of sample (S).

8. The method according to claim 7, wherein a sample (S) is failing when his connector resistance (R) is greater than a resistance threshold (RT).

9. The method according to anyone of claims 7 or 8, wherein a prolongation of the duration of the vibrating test is simulated by extrapolating the connector resistance (R) according to a lognormal or Weibull law, until obtaining the failure.

10. The method according to anyone of claims 1 to 9, wherein the total number of sample (S) is at least equal to fifty.
